Europäisches Patentamt

European Patent Office

Office européen des brevets

(19)

(11) Publication number: 0 242 020
A2

## (12) EUROPEAN PATENT APPLICATION

(21) Application number: 87300900.5

(51) Int. Cl.4: **H05K 1/00 , H05K 3/00**

(22) Date of filing: 02.02.87

(30) Priority: 16.04.86 GB 8609226

(43) Date of publication of application:
21.10.87 Bulletin 87/43

(84) Designated Contracting States:
AT BE CH DE ES FR GB GR IT LI LU NL SE

(71) Applicant: MARCONI ELECTRONIC DEVICES
LIMITED
The Grove Warren Lane
Stanmore Middlesex HA7 4LY(GB)

(72) Inventor: Doyle, Barrie
Radnor House Cirencester Road
Tetbury Gloucestershire(GB)
Inventor: Anderson, Russell David
41 Ely Close Toothill
Swindon Wiltshire(GB)

(74) Representative: Hoste, Colin Francis
The General Electric Company p.l.c. Central
Patent Department (Chelmsford Office)
Marconi Research Centre West Hanningfield
Road
Great Baddow Chelmsford CM2 8HN,
Essex(GB)

(54) Electrical circuits.

(57) An electrical circuit is formed as a pattern of
conductive ink upon one surface of a flexible trans-
parent substrate, the other surface of which carries a
layer of contact adhesive by means of which the
completed circuit is attached to a support. The ink is
screen printed to form an intricate pattern of conduc-
tors, and is cured at a low temperature to avoid
damage to the substrate. The support can form part
of the housing of electrical apparatus which is too
inaccessible or awkwardly shaped for the circuit to
be formed in situ.

FIG. 1.

## ELECTRICAL CIRCUITS

This invention relates to electrical circuits and more particularly to circuits in which electrically conductive tracks are laid down as a settable fluid upon an insulating substrate. Such circuits are generally termed printed circuits or hybrid circuits and the substrate is conventionally in the form of a flat strong board composed of fibreglass or ceramic. It has been proposed to form electrical circuits upon an insulating surface which is not necessarily flat, but which can form the structural part of an equipment or apparatus or part of its housing. It can be very difficult to fabricate a circuit on such a surface as special and expensive jigs and equipment are needed. The present invention seeks to provide an improved electrical circuit in which the difficulties can be reduced.

According to a first aspect of this invention an electrical circuit includes a thin flexible sheet of an insulating material, one surface of which carries a printed pattern of conductive ink, and the other surface of which is adhesive.

The thin flexible sheet can be held flat whilst the pattern of conductors is formed by a conventional process of printing conductive inks without the need for specially shaped jigs, after which the flexible substrate is attached by its adhesive surface to a shaped member which supports it.

It is preferred that the thin flexible sheet is a plastics material, and that the conductive pattern is formed by the screen printing of an electrical polymer ink which is cured at a low temperature, i.e. of the order of 200°C or less, as such temperatures do not damage the substrate or result in significant distortion. Preferably an adhesive coating is present on the other surface of the substrate prior to the printing process, the coating being protected by a nonstretch release film in contact therewith, which serves to stabilise the shape of the substrate.

According to a second aspect of this invention a method of making an electrical circuit includes the steps of coating one surface of a thin flexible sheet of insulating material with an adhesive which is covered with a release film; printing conductive ink upon the other surface of the sheet to constitute a pattern of conductive tracks and curing said ink so as to set it; removing said release film and attaching the flexible sheet to a support by means of the adhesive coating.

The invention is further described by way of example with reference to the accompanying drawings in which:

Figure I is a sectional view through an electrical circuit,

Figure 2 is a plan view of such a circuit and

Figure 3 shows the electrical circuit mounted on electrical equipment.

Referring to Figures I and 2, there is shown therein an electrical circuit consisting of a thin flexible electrically insulating substrate I which carries a pattern of conductive tracks 2 upon one surface thereof. Typically, the substrate I is a plastics material, commonly termed ABS, i.e. "acrylonitrile butadienestyrene". This film is typically 25 to 50 microns thick and as such it is relatively fragile and very flexible. The rear surface of the substrate I carries a thin coating 3 of a contact adhesive material which is such as to form a bond when it is pressed firmly against a suitable surface. To prevent such a bond forming before it is intended, a release film 4 s provided in contact with the adhesive coating 3. Typically, this release film 4 is waxed paper which being a nonstretchable material, serves to hold the substrate I in its correct form so as to prevent undesired localised stretching during handling or manufacture. The pattern of conductors is formed by printing conductive inks upon the upper surface of the substrate I.

The conductive tracks 2 are formed by means of a conductive ink using a conventional screen printing process. A screen is used which consists of a very fine mesh, typically about I00 wires per centimetre, which is coated with photosensitive emulsion which is then set at desired regions using a photolithographic technique to produce a mask, portions of which are opaque (and seal the interstices of the mesh) and portions of which are open (constituting the open mesh). Thus the circuit pattern, which can be intricate and complex, is determined by the photolithographic mask. The ink is subsequently applied as a fluid to the surface of the mesh screen and is forced through the open portions of the mesh by means of a squeegee or roller. the ink of course, passing only through the open mesh regions of the screen. By suitable choice of the pitch of the mesh. the spacing of the mesh from the surface. and the viscosity of the ink, a geometrical pattern of high resolution and sharpness can be formed in which the ink constitutes electrical tracks. The resolution of the geometry can be fairly fine, 250 to 500 microns resolution being readily achievable. Inks with different electrical properties i.e. conductive or resistive, can be deposited using separate screens to form more complex multilayer circuits which are capable of exhibiting a variety of different electrical functions.

After the pattern of ink has been formed upon the substrate I, the ink is cured by heating it to a temperature of about I50°c for about an hour. It is found that after this period of curing the ink sets and adheres well to the substrate I.

The polymer ink may be chosen so as to have a very low resistivity so that it acts purely as a conductor, or alternatively it may be chosen so as to exhibit predetermined resistivity so that it is used to form resistors of specified values. In each case, the electrical property is primarily determined by the size and nature of particles carried within the ink, and thus the mask which is used during the screen printing process, must be chosen with regard to the particle size of the ink.

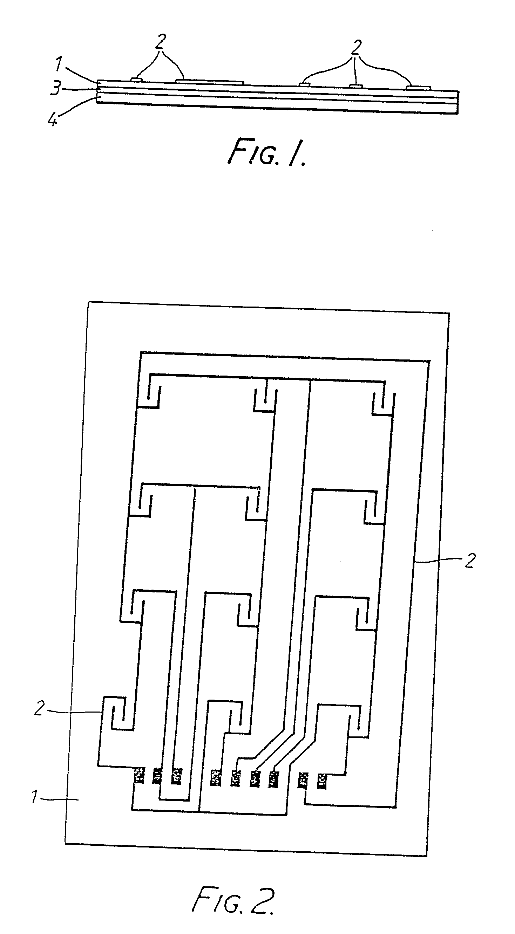

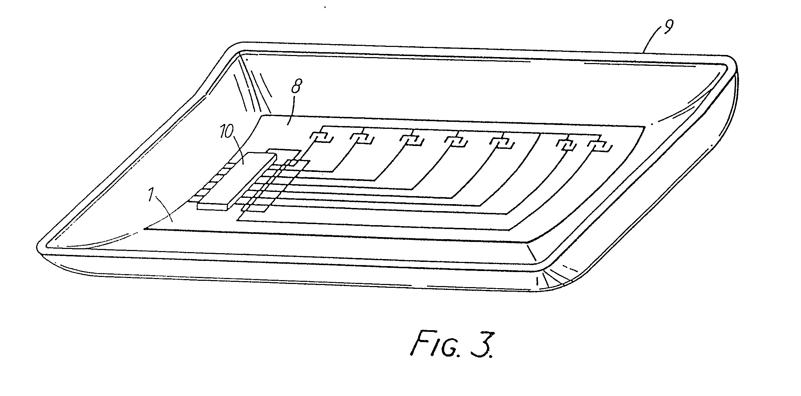

Figure 2 illustrates a typical conductive pattern which is formed in this way so as to constitute an electrtical circuit. Small lightweight electrical elements can be bonded directly on to this substrate so as to incorporate discrete components such as transistors and logic elements. Alternatively, and preferably, the circuit may comprise a pattern of contacts which can form part of a switch arrangement or an interconnect circuit in which no discrete components are added. During the printing process, and the subsequent low temperature curing of the conductive inks the plastics substrate I is held and supported by the release film 4 so as to reduce any tendency for the film to stretch or distort. In order to hold the substrate flat during the printing process, it is desirable to use a vacuum bed which applies a suction to the underside of the release film 4 so as to hold the substrate flat.

Following completion of the electrical circuit it can be stored for a considerable period of time with the release film 4 in place so as to protect the adhesive coating 3. Then, as needed, the release film 4 is removed to expose the adhesive 3, and the electrical circuit is mounted upon a support such as is shown in Figure 3. Figure 3 shows part of a keyboard consisting of a moulded plastics housing having a curved base 8, which is recessed below upstanding walls 9. In this instance the flexible circuit substrate I is simply pressed firmly against a suitable and predetermined part of the base 8 so that on contact a pressure bond forms with the adhesive. As the substrate I is very thin and flexible, it can conform easily to any changes in profile in the base 8. In particular, it can follow curves and corners in the surface and can be recessed into what would normally be fairly inaccessible parts of an equipment. In this example a corrector I0 is attached to the substrate I after the substrate has been mounted firmly on the base 8.

Thus many parts of the casing or lid of an equipment, which are normally quite unsuitable for supporting or forming part of an electrical circuit can be utilised as the support for an electrical circuit made in this way. Furthermore, the circuits can be easily stored with the release film 4 in place without deterioration until needed.

It is preferred to use a contact adhesive which is initially soft and flexible but which can be converted into a permanent rigid bond on exposure to ultraviolet radiation, followed by a low temperature thermal cure. This serves to stabilise the electrical circuit and to prevent it subsequently peeling off from its support. To facilitate this the substrate I consists of a transparent plastics material so that the ultra-violet light can readily be received by the adhesive.

## Claims

1. An electrical circuit including a thin flexible sheet of an insulating material, one surface of which carries a printed pattern of conductive ink, and the other surface of which is adhesive.

2. An electrical circuit as claimed in claim I and wherein the sheet is a plastics material.

3. An electrical circuit as claimed in claim I or 2 and wherein the printed pattern is formed by the screen printing of an electrical polymer ink which is cured at a low temperature of the order of 200°C or less.

4. An electrical circuit as claimed in any of the preceding claims and wherein the thin flexible sheet is transparent.

5. An electrical ciruit as claimed in any of the preceding claims and wherein a substantially non-stretchable release film is present in contact with said adhesive surface.

6. An electrical circuit as claimed in claim 5 and wherein the release film is composed of waxed paper.

7. An electrical circuit arrangement including a planar support which carries an electrical circuit in contact therewith as claimed in any of the preceding claims I to 4.

8. A method of making an electrical circuit including the steps of coating one surface of a thin flexible sheet of insulating material with an adhesive which is covered with a release film; printing conductive ink upon the other surface of the sheet to constitute a pattern of conductive tracks and curing said ink so as to set it; removing said release film, and attaching the flexible sheet to a support by means of the adhesive coating.

9. A method as claimed in claim 8 and wherein the sheet of insulating material is coated with the adhesive before the conductive ink is printed upon the sheet.

10. A method as claimed in claim 8 or 9 and wherein the conductive ink is printed upon localised regions of the sheet by a screen printing process.

11. A method as claimed in claim 10, and wherein the printed ink is cured at a temperature less than 200°C.

12. A method as claimed in any of claims 8 to 11 and wherein after the flexible sheet is attached to the support the adhesive coating is cured by exposing it to ultra-violet light to harden it.

0 242 020

FIG. 1.

FIG. 2.

FIG. 3.

0 242 020